# FASCICULE DE BREVET EUROPEEN

(11) **EP 3 824 304 B1**
(45) Date de publication et mention de la délivrance du brevet: **28.08.2024**
(21) Numéro de dépôt: 19756425.5
(22) Date de dépôt: 16.07.2019
(51) Int. Cl.: G01R 31/36

(54) **PROCÉDÉ DE DÉTERMINATION DE L'ÉTAT DE FONCTIONNEMENT D'UNE BATTERIE ET BATTERIE METTANT EN OEUVRE UN TEL PROCÉDÉ**
VERFAHREN ZUR BESTIMMUNG DES BETRIEBSZUSTANDS EINER BATTERIE UND BATTERIE MIT IMPLEMENTIERUNG SOLCH EINES VERFAHRENS
METHOD FOR DETERMINING THE OPERATING STATE OF A BATTERY AND BATTERY IMPLEMENTING SUCH A METHOD

(30) Priorité: 17.07.2018 FR 1856603
(43) Date de publication de la demande: 26.05.2021
(73) Titulaire: Safran Electrical & Power, 31702 Blagnac Cedex (FR)
(72) Inventeur: SAYEGH, Marie, 77550 Moissy Cramayel (FR)
(74) Mandataire: Casalonga
(86) Numéro de dépôt international: PCT/FR2019/051783
(87) Numéro de publication internationale: WO 2020/016521

(56) Documents cités:
- WO-A1-2015/101731
- US-A- 4 968 942
- US-A1- 2015 292 958
- US-B1- 9 157 968

## Description

L'invention concerne, de manière générale, les batteries de cellules d'accumulateurs électriques et concerne plus particulièrement le contrôle du bon fonctionnement d'une telle batterie afin de s'assurer que la batterie est capable de satisfaire à des conditions de fonctionnement, ou profils d'utilisation, qui lui sont imposés.

Plus particulièrement, l'invention se rapporte à un procédé de détermination de l'état de fonctionnement d'une batterie embarquée à bord d'un aéronef.

Traditionnellement, en cas de défaillance d'une batterie, son système de contrôle se charge de prendre certaines mesures, en commençant souvent par déconnecter la batterie du réseau électrique auquel elle est raccordée.

La batterie communique avec le système de distribution électrique uniquement sur son état de fonctionnement.

En effet, une batterie peut être indisponible, vis-à-vis d'un profil d'utilisation qui lui est demandé, en raison d'une modification de ses paramètres qui influent sur ses performances.

L'incapacité de la batterie peut provenir d'un état de charge, ou SOC (pour « State of Charge », en anglais), insuffisant ou d'une baisse de ses performances en raison d'une température trop basse.

En effet, lorsque la température de la batterie diminue, la capacité disponible, c'est-à-dire la capacité qu'elle est capable d'échanger avec une charge, diminue. De même, la valeur de la résistance interne de la batterie augmente lorsque la température baisse, engendrant une chute consécutive de la tension délivrée. Ainsi, lorsque la tension que la batterie est capable de fournir baisse en dessous d'une valeur de seuil minimale, la batterie devient incapable d'accomplir la mission qui lui est confiée. Alors que la capacité disponible de la batterie dépend des conditions opérationnelles, la capacité stockée est celle qui est réellement présente dans la batterie. Lorsque les conditions de fonctionnement sont optimales, la capacité disponible rejoint la capacité stockée. Tel est en particulier le cas à faible régime de courant ou à température élevée.

Outre les paramètres de la batterie précités, l'incapacité de la batterie à délivrer un profil d'utilisation peut également provenir de son vieillissement qui dépend des conditions d'usage et de stockage de la batterie.

Le vieillissement de la batterie influe sur la capacité disponible de la batterie mais également sur sa résistance interne, contribuant ainsi à limiter la disponibilité de la batterie, en fonction de son vieillissement.

On connaît, dans l'état de la technique, des méthodes permettant d'estimer l'aptitude d'une batterie à fournir un profil de puissance prédéterminée. Cependant de telles méthodes ne sont pas satisfaisantes.

On pourra se référer au document US 4 968 942 dans lequel des paramètres d'une batterie sont comparés avec des besoins de puissance, au document WO 2015/101731 qui décrit un procédé de détermination de l'aptitude ou de l'inaptitude d'une batterie à fournir un niveau de puissance, ou encore au document US 2015/292958 qui décrit un procédé de contrôle d'un dispositif électrique par mesure d'un paramètre du dispositif, en fonctionnement.

Au vu de ce qui précède, l'invention a pour objectif d'analyser l'état de fonctionnement d'une batterie vis-à-vis d'un profil d'utilisation prédéterminé.

Un autre but de l'invention est de fournir un procédé de détermination de l'état de fonctionnement d'une batterie rendant possible de fournir l'état de fonctionnement de la batterie vis-à-vis d'un profil d'utilisation afin, notamment, de mettre en oeuvre des mesures permettant d'agir sur les paramètres de fonctionnement de la batterie pour qu'elle soit en mesure de satisfaire au profil d'utilisation qui lui est demandé.

L'invention a donc pour objet, selon un premier aspect, un procédé de détermination de l'état de fonctionnement d'une batterie vis-à-vis d'un ou de plusieurs profils d'utilisation tel que défini dans la revendication indépendante 1.

Ainsi, la phase d'apprentissage préalable permet de connaître, pour chaque profil d'utilisation, les limites opérationnelles entre un état disponible et un état indisponible et ce, en fonction des paramètres de la batterie.

Il est ainsi possible de connaître la disponibilité future de la batterie pour un profil d'utilisation à tester par comparaison avec les limites opérationnelles prédéterminées.

Dans un mode de mise en oeuvre, les paramètres de la batterie comprennent la température, le niveau de charge de la batterie et un ou des paramètres de vieillissement de la batterie.

Par exemple, les paramètres de vieillissement de la batterie sont la résistance interne et la capacité disponible de la batterie.

L'invention a également pour objet, selon un autre aspect, une batterie comprenant un système de gestion de l'état de fonctionnement de la batterie telle que définie dans la revendication indépendante 4.

D'autres buts, caractéristiques et avantages de l'invention apparaîtront à la lecture de la description suivante, donnée uniquement à titre d'exemple non limitatif, et faite en référence aux figures annexées sur lesquelles :
- la figure 1 montre la limite opérationnelle d'une batterie, en fonction de l'évolution de la température et de l'état de charge, qui est obtenue à l'issue de la première phase d'apprentissage ;
- la figure 2 montre l'évolution de la limite opérationnelle d'une batterie en fonction de la variation de l'état de charge, de la température de la batterie et de son état de vieillissement, qui est obtenue à l'issue de la première phase d'apprentissage ;
- la figure 3 montre les principales étapes de la phase de test du procédé selon l'invention ; et
- la figure 4 est une vue schématique d'une batterie mettant en oeuvre un procédé conforme à l'invention.

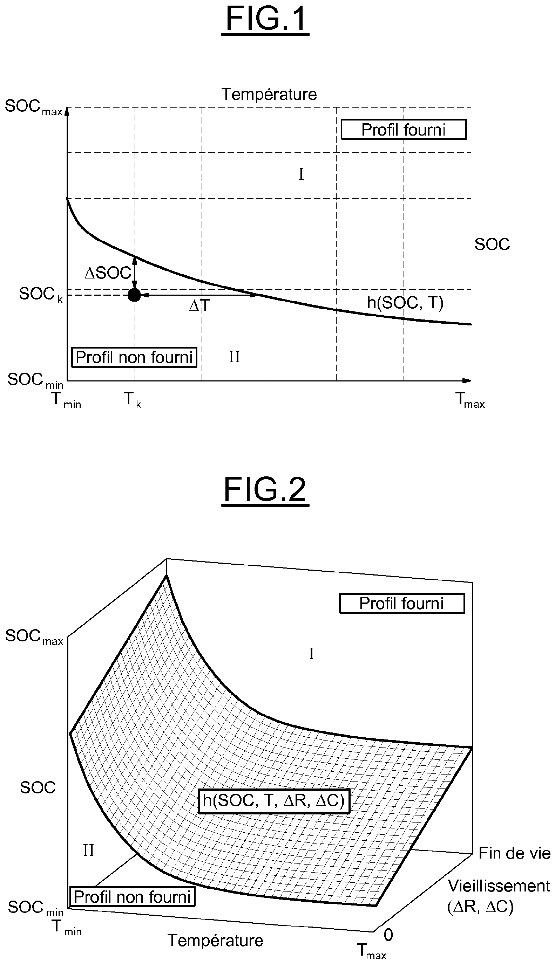

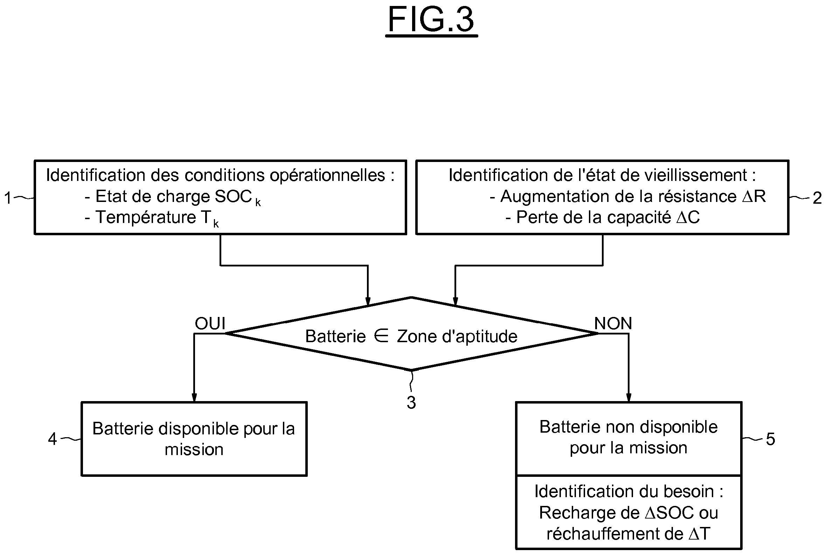

On va maintenant décrire, en référence aux figures 1 à 3 les principales phases d'un procédé de détermination de l'état de fonctionnement d'une batterie selon un mode de mise en oeuvre de l'invention. Ce procédé est par exemple mis en ouvre pour contrôler le fonctionnement d'une batterie dans un système embarqué, notamment embarqué à bord d'un aéronef.

Ce procédé est avantageusement mis en oeuvre par un système de gestion qui est par exemple intégré à la batterie et qui est dûment programmé pour mettre en oeuvre un tel procédé.

Le procédé selon l'invention comporte essentiellement deux phases constituant l'une une phase d'apprentissage et l'autre une phase de test proprement dite.

Au cours de la phase d'apprentissage, on détermine les limites opérationnelles de la batterie pour un ensemble de profils d'utilisation, en fonction de la valeur de paramètres de la batterie qui vont influer sur ses performances.

Ces paramètres de fonctionnement sont notamment la température de la batterie et l'état de charge (SOC) de la batterie.

Cette phase d'apprentissage préalable consiste à mettre en oeuvre des tests, pour chaque profil d'utilisation d'un ensemble de profils d'utilisations prédéterminés. Ces tests sont effectués, pour chaque profil d'utilisation, à plusieurs températures et états de charge, afin de déterminer les limites opérationnelles de la batterie pour le profil d'utilisation en question.

Comme illustré sur la figure 1, ces phases de test sont par exemple réalisées entre une valeur de température minimale Tmin jusqu'à une valeur de température maximale Tmax et pour des états de charge compris entre une valeur minimale SOCmin et une valeur maximale SOCmax. Chaque phase de test consiste à vérifier si la batterie, pour une température T et un état de charge SOC donnés est capable de fournir le profil d'utilisation qui lui est demandé, en terme de niveau de tension, de niveau de courant, de puissance ou d'énergie électrique, pour une durée ou des plages de durées prédéfinies.

La limite opérationnelle est ici une fonction h(SOC,T) qui permet d'effectuer une discrimination entre un état opérationnel de la batterie « profil fourni » (zone I) vis-à-vis d'un profil opérationnel donné et un état non opérationnel « profil non fourni » (zone II) vis-à-vis du profil d'utilisation envisagé.

Comme le montre la figure 2, ces tests sont en outre réalisés pour divers états de vieillissement, c'est-à-dire pour diverses valeurs de variation de résistance interne et de la capacité disponible de la batterie ΔR et ΔC variant entre 0, pour une batterie neuve, et ΔRmax et ΔCmax.

Ainsi, la limite opérationnelle entre un état opérationnel et un état non opérationnel vis-à-vis d'un profil d'utilisation donné est délimitée par une surface h(SOC,T,ΔR,ΔC) variant en fonction de l'état de charge entre une valeur minimale SOCmin et une valeur maximale SOCmax et des valeurs de température variant entre une valeur minimale Tmin et une valeur maximale Tmax et variant en fonction du vieillissement de la batterie, entre un état neuf (ΔR=0 et ΔC=0) et un état de vieillissement maximal (ΔR= ΔRmax et ΔC= ΔCmax).

Lors d'une phase de test proprement dite de la batterie, pour vérifier si la batterie est capable de fournir un profil d'utilisation à tester, lors d'une première étape 1 on procède à une identification des paramètres actuels de la batterie. Ces paramètres sont ici constitués par les conditions opérationnelles comprenant l'état de charge SOCk et la température Tk.

On procède également à l'identification de l'état de vieillissement de la batterie en déterminant l'augmentation de la résistance interne ΔR et la perte de capacité ΔC (étape 2).

Cet état de vieillissement, et en particulier les valeurs d'augmentation de la résistance interne et de capacité, peut être obtenue au moyen de techniques conventionnelles, par exemple à l'aide d'un algorithme par test.

En se référant par exemple à la figure 1, le point de fonctionnement ainsi déterminé (SOCk,Tk) est déterminé par rapport à la limite opérationnelle.

Ainsi, lors de l'étape 3 suivante, on compare le point de fonctionnement ainsi déterminé et la limite opérationnelle.

Si la batterie se situe dans la zone d'aptitude, on considère alors que la batterie est disponible pour la mission qui lui est confiée (étape 4).

Si tel n'est pas le cas, on considère que la batterie est indisponible (étape 5).

Toutefois, au cours de cette étape, on détermine les variations ΔSOC et ΔT à apporter à l'état de charge, d'une part, et à la température, d'autre part, pour lui permettre d'atteindre la zone opérationnelle.

La valeur de réchauffement ΔT est notamment un indicateur interne à la batterie puisque le réchauffeur, lorsqu'il est présent, est généralement intégré dans la batterie et est régulé par le système de contrôle.

La demande de recharge est par contre un indicateur externe qui est délivré à l'extérieur de la batterie pour provoquer sa recharge.

Dans le mode de mise en oeuvre qui vient d'être décrit, les limites opérationnelles sont fixées pour chaque profil d'utilisation.

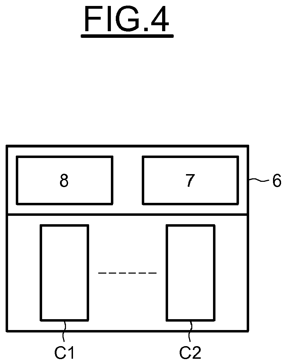

En référence à la figure 4, le procédé qui vient d'être décrit peut avantageusement être mis en oeuvre au sein d'une batterie comprenant un ensemble de cellules C1,..., Cn et un système de gestion 6 comportant des moyens de mémorisation 7 dans lesquels sont stockées des limites opérationnelles de la batterie en fonction de paramètres de la batterie qui influent sur les performances de la batterie, pour un ensemble de profils d'utilisation, et des moyens de calculs 8 intégrant des moyens pour déterminer des paramètres actuels de la batterie et des moyens pour comparer un profil d'utilisation à tester à des limites opérationnelles extraites des moyens de mémorisation et correspondant auxdits paramètres actuels, pour ledit profil d'utilisation à tester.

Dans le texte on mentionne que la disponibilité de la batterie dépend de l'état de vieillissement (ΔR et ΔC) mais on n'a pas précisé comment identifier cet état. Cet état peut être obtenu par des moyens usuels de type algorithme et/ou de tests.

## Revendications

1. Procédé de détermination de l'état de fonctionnement d'une batterie vis-à-vis d'un ou de plusieurs profils d'utilisation, comprenant :
- une étape d'apprentissage préalable au cours de laquelle on définit, pour un ou plusieurs profils d'utilisation, des limites opérationnelles de ladite batterie en fonction de paramètres de la batterie; lesdites limites opérationnelles délimitant une zone opérationnelle dans laquelle la batterie exécute le ou les profils d'utilisation et une zone non opérationnelle dans laquelle la batterie n'exécute pas le ou les profils d'utilisation,
- une étape de détermination de l'état de fonctionnement de la batterie pour un profil d'utilisation donné au cours de laquelle on détermine les paramètres de la batterie en fonctionnement, et
- une étape de comparaison dans laquelle on compare les limites opérationnelles issues de l'étape d'apprentissage et les paramètres de la batterie en fonctionnement issus de l'étape de détermination et on positionne la batterie dans la zone opérationnelle ou non opérationnelle, **caractérisé en ce qu'**il comprend en outre une étape d'analyse dans laquelle on analyse le ou les paramètres à ajuster pour que la batterie revienne dans la zone opérationnelle, le ou les paramètres à ajuster étant la température de la batterie.

2. Procédé selon la revendication 1, dans lequel les paramètres de la batterie comprennent la température, le niveau de charge de la batterie et un ou des paramètres de vieillissement de la batterie.

3. Procédé selon la revendication 2, dans lequel les paramètres de vieillissement de la batterie sont la résistance interne et la capacité disponible de la batterie.

4. Batterie comprenant un système de gestion de l'état de fonctionnement de la batterie, le système de gestion (6) comportant des moyens de mémorisation (7) dans lesquels sont stockées des limites opérationnelles de la batterie en fonction de paramètres de la batterie, lesdites limites opérationnelles délimitant une zone opérationnelle dans laquelle la batterie exécute le ou les profils d'utilisation et une zone non opérationnelle dans laquelle la batterie n'exécute pas le ou les profils d'utilisation, des moyens (8) pour déterminer des paramètres de la batterie en fonctionnement pour un profil d'utilisation donné, des moyens de calcul (8) pour comparer les limites opérationnelles stockées dans les moyens de mémorisation et lesdits paramètres de la batterie et pour positionner la batterie dans la zone opérationnelle ou non opérationnelle,
**caractérisé en ce que** les moyens de calcul (8) sont configurés et- pour analyser le ou les paramètres à ajuster pour que la batterie revienne dans la zone opérationnelle, le ou les paramètres à ajuster étant la température de la batterie.

## Patentansprüche

1. Verfahren zum Bestimmen eines Betriebszustands einer Batterie in Bezug auf ein oder mehrere Nutzungsprofile, Folgendes umfassend:
- einen vorherigen Schritt des Lernens, während dem Betriebsgrenzen der Batterie für das eine oder die mehreren Nutzungsprofile in Abhängigkeit von Parametern der Batterie definiert werden, wobei die Betriebsgrenzen eine Betriebszone, in der die Batterie das oder die Nutzungsprofile ausführt, und eine Nichtbetriebszone begrenzen, in der die Batterie das oder die Nutzungsprofile nicht ausführt,
- einen Schritt des Bestimmens des Betriebszustands der Batterie für ein gegebenes Nutzungsprofil, während dem die Parameter der Batterie während des Betriebs bestimmt werden, und
- einen Schritt des Vergleichens, während dem die aus dem Lernschritt stammenden Betriebsgrenzen und die aus dem Bestimmungsschritt stammenden Parameter der Batterie während des Betriebs verglichen werden und die Batterie in der Betriebs- oder Nichtbetriebszone angeordnet wird, **dadurch gekennzeichnet, dass** es ferner einen Schritt des Analysierens umfasst, während dem der oder die Parameter, die einzustellen sind, damit die Batterie wieder in die Betriebszone kommt, analysiert werden, wobei der oder die einzustellenden Parameter die Temperatur der Batterie sind.

2. Verfahren nach Anspruch 1, wobei die Parameter der Batterie die Temperatur, den Ladezustand der Batterie und einen oder mehrere Alterungsparameter der Batterie umfassen.

3. Verfahren nach Anspruch 2, wobei die Alterungsparameter der Batterie der innere Widerstand und die verfügbare Kapazität der Batterie sind.

4. Batterie, die ein Verwaltungssystem für den Betriebszustand der Batterie umfasst, wobei das Verwaltungssystem (6) eine Speichereinrichtung (7), in der die Betriebsgrenzen der Batterie in Abhängigkeit von den Parametern der Batterie gespeichert sind, wobei die Betriebsgrenzen einen Betriebsbereich, in dem die Batterie das oder die Nutzungsprofile ausführt, und einen Nichtbetriebsbereich begrenzen, in dem die Batterie das oder die Nutzungsprofile nicht ausführt, eine Einrichtung (8) zum Bestimmen der Parameter der Batterie während des Betriebs für ein gegebenes Nutzungsprofil, und eine Recheneinrichtung (8) zum Vergleichen der in der Speichereinrichtung gespeicherten Betriebsgrenzen und zum Anordnen der Batterie in der Betriebs- oder Nichtbetriebszone enthält,
**dadurch gekennzeichnet, dass** die Recheneinrichtung (8) dazu konfiguriert ist, den oder die Parameter, die einzustellen sind, damit die Batterie wieder in die Betriebszone kommt, zu analysieren, wobei der oder die einzustellenden Parameter die Temperatur der Batterie sind.

## Claims

1. Method for determining the operating state of a battery with respect to one or more use profiles, comprising:
- a prior learning step during which, for one or more use profiles, operational limits of said battery are defined according to parameters of the battery, said operational limits delimiting an operational zone in which the battery implements the use profile or profiles and a non-operational zone in which the battery does not implement the use profile or profiles,
- a step of determining the operating state of the battery for a given use profile during which the parameters of the battery in operation are determined, and
- a comparison step in which the operational limits resulting from the learning step and the parameters of the battery in operation resulting from the determination step are compared and the battery is positioned in the operational or non-operational zone, **characterised in that** it furthermore comprises an analysis step in which the parameter or parameters to be adjusted so that the battery returns to the operational zone are analysed, the parameter or parameters to be adjusted being the temperature of the battery.

2. Method according to claim 1, in which the parameters of the battery comprise the temperature, the battery charge level and one or more battery aging parameters.

3. Method according to claim 2, wherein the battery aging parameters are the internal resistance and the available capacity of the battery.

4. Battery comprising a system for managing the operating state of the battery, the management system (6) including memory means (7) in which operational limits of the battery according to the parameters of the battery are stored, said operational limits delimiting an operational zone in which the battery implements the use profile or profiles and a non-operational zone in which the battery does not implement the use profile or profiles, means (8) for determining parameters of the battery in operation for a given use profile, computing means (8) for comparing the operational limits stored in the memory means and said parameters of the battery and for positioning the battery in the operational or non-operational zone, **characterised in that** the computing means (8) are configured to analyse the parameter or parameters to be adjusted so that the battery returns to the operational zone, the parameter or parameters to be adjusted being the temperature of the battery.
